# EUROPEAN PATENT APPLICATION

(11) **EP 1 369 919 A1**
(43) Date of publication of application: **10.12.2003**
(21) Application number: 02253674.2
(22) Date of filing: 24.05.2002
(51) Int. Cl.: H01L 23/498, H01L 23/433, H01L 21/60, H01L 23/367

(54) **Flip chip package**

(71) Applicant: Ultratera Corporation, Hsin-Chu (TW)
(72) Inventor: Maa, Chong-Ren, Sungshan Chiu, Taipei (TW); Chich, Wan-Kuo, Judung Jen, Hsinchu (TW); Tsai, Ming-Sung, Nuannuan Chiu, Keelung (TW); Shan, Wei-Heng, Hsin-Chu, Taiwan 300 (TW)
(74) Representative: O'Connell, David Christopher

(57) **Abstract**

A flip chip package has a substrate (14) made of a material including an epoxy resin. A solder mask (30) is one layer of an epoxy resin disposed on the top surface of the substrate (14). The solder mask (30) has a smooth outer surface and a plurality of openings (34) to expose the conductive patterns (24) formed on the top surface. An IC chip (12) includes an active side having a plurality of electrical contact pads (22). A plurality of solder bumps (36), each bump (36) is formed on a respective one of the plurality of contact pads (22) on the IC chip. The active side of the IC chip is tightly attached to the outer surface of the solder mask (30) such that after a soldering process each said bump (36) has a remainder (36a) completely received in a respective one of the opening of the solder mask (30) and connected to the conductive patterns therein.

## Description

### BACKGROUND OF THE INVENTION

### 1. Field of the Invention

This invention relates to encapsulated flip chips, and more particularly to a low cost flip chip package with high package reliability.

### 2. Description of the Prior Art

Flip chip technology is well known in the art for electrically connecting an integrated circuit (IC) chip to a printed circuit substrate or package. Formation of one type of flip chip involves forming solder bumps on electrical interconnection pads on the active or front side of an IC chip, attaching the active side of the chip to the top surface of a substrate, and using the solder bumps after a soldering process to connect the contact pads on the active side of the chip and the respective contact pads forming on the top surface of the substrate. Such a flip chip package mentioned above often has a gap between the chip and the substrate due to the remainders of the solder bumps after the soldering process and the bending of the substrate during the manufacturing procedure thereof. In order to strengthen the solder joints without affecting the electrical connection, the gap is customarily underfilled with a polymeric material, sometimes referred to as the "underfill", which encapsulates the remainders of the solder bumps and fills all of spaces in the gap.

The need of the underfill has some drawbacks. For example, the elevated temperature and the temperature cycling needed for curing the underfill can create mechanical stresses in contact areas among the chip, the underfill and the substrate. Many voids will be formed during the underfilling process. The mechanical stresses and voids are detrimental to the chip and the solder interconnections. Additionally, the underfill can increase the producing cost and the size, specifically in thickness, of the package.

### SUMMARY OF THE INVENTION

It is therefore the primary objective of the present invention to provide an improved flip chip package which is underfill-free.

It is another objective of the present invention to provide an improved flip chip package which has superior heat dissipation characteristics and good electrical performance.

In keeping with the principle of the present invention, the foregoing objectives of the present invention are attained by the flip chip package comprising a substrate member having top and bottom surfaces, a conductive pattern at least on one of the surfaces. The substrate is made of a material including a first resin. A solder mask is made of a material including a second resin having a thermal expansion coefficient substantially identical to that of the first resin of the substrate. The solder mask is disposed on the top surface of the substrate such that it has a smooth outer surface and a plurality of opening, each opening exposing a respective area of the conductive patterns of the substrate. An IC chip has an active side, an inactive side and a plurality of electrical contact pads on the active side. A plurality of solder bumps, each bump is formed on a respective one of the plurality of contact pads on the IC chip. The active side of the IC chip is directly attached to the outer surface of the solder mask such that after a soldering process each said bump has a remainder completely received in a respective one of the opening of the solder mask and connected to the conductive patterns therein. A molding material encapsulates the chip and the top surface of the substrate.

The foregoing objectives, features, and advantages of the present invention will be more readily understood upon a thoughtful deliberation of the following detailed description of a preferred embodiment of the present invention with reference to the accompanying drawings.

### BRIEF DESCRIPTION OF THE DRAWINGS

FIG.1 is a cross-sectional side view of a flip chip package constructed in accordance with an embodiment of the present invention;
FIG.2 is an enlarged side view of a portion of the chip and the substrate prior to being bonded together in accordance with the package as seen in FIG.1;
FIG.3 is a cross-sectional side view of a flip chip package constructed in accordance with another embodiment of the present invention; and
FIG.4 illustrates the method of forming a solder mask on a substrate according to the present invention.

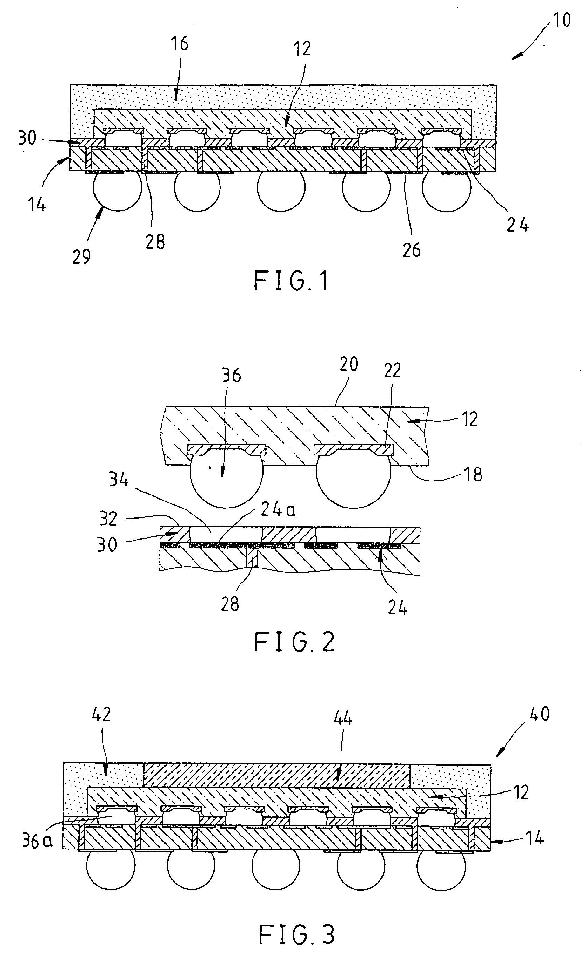

As shown in FIGS. 1 and 2, there depicts an embodiment of a package 10 according to the present invention. The package 10 includes an IC chip 12, a substrate 14, and a molding material 16 encapsulating the chip and, the substrate.

The IC chip 12 has an active side 18 and an inactive side 20 which are planar and parallel to each other. A plurality of contact pads 22 are disposed on active side 18.

The substrate 14 has conductive patterns 24 and 26 on the top surface of the substrate 14 and the bottom surface respectively. The substrate 14 is typically made of a glassfiber reinforced epoxy resin laminate. The conductive pattern 24 is electrically connected from the top surface of the substrate 14 to the patterns 26 on the bottom surface by way of a plurality of conductive vias 28. A plurality of solder balls 29, each ball is attached at a respective area of the conductive patterns 26 to attach to a circuit system.

An epoxy resin is applied to the top surface of the substrate such that the conductive vias 28 and the spaces between the conductive patterns 24 are filled by the epoxy resin, and one layer of an epoxy resin having a predetermined thickness is formed over the conductive patterns 24 which serve as a solder mask 30. The method to form the solder mask 30 is detailedly described below.

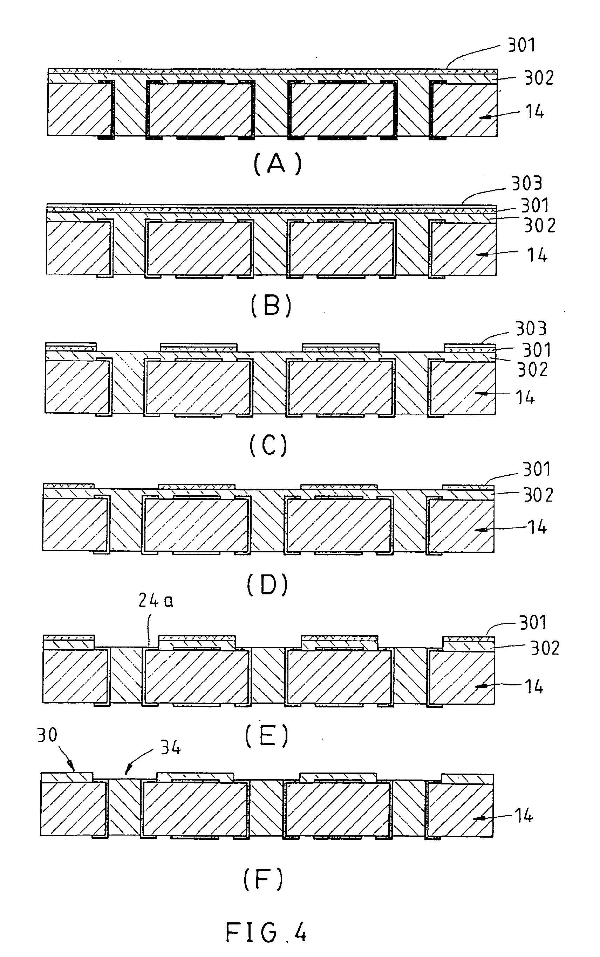

Referring to FIG.4A, a metal foil 301 (e.g. a copper or aluminum foil) coated with a layer 302 of a partially cured (B-staged) epoxy resin to one side thereof is applied to the top surface of the substrate 14 such that the layer 302 is sandwiched between the substrate 14 and the metal foil 301.

The coated metal foil 301 and the substrate 14 are laminated with a pressure of 10∼40kgw/cm² and a temperature of 140°C∼185°C for 1.5 hours to 3 hours such that the epoxy resin layer 302 is cured and tightly covers the substrate 14.

The metal foil 301 surface is covered with a photo-resist layer 303 (as shown in FIG.4B). The photo-resist is photocured using a mask which allows only the positions to be accessed to remain uncured, and then the uncured areas of the photo-resist and the metal foil thereunder are removed with suitable solvents to expose the underlying epoxy resin layer 302 (as shown in FIG.4C).

Subsequently, the residual (cured) portion of the photo-resist is removed with suitable solvents (as shown in FIG.4D), and then the underlying epoxy resin 302 is removed by a plasma etching method to expose the conductive pattern 24a on the substrate (as shown in FIG.4E).

Lastly, an etching method is applied to remove the residual metal foil 301, leaving the fully cured epoxy resin layer 302 as the solder mask 30 (as shown in FIG.4F).

The solder mask 30 made by the method described above has a smooth outer surface 32, a thickness of 5 µm ∼30 µm ( the best thickness is 15 µm) and a series of openings 34 to expose the conductive patterns 24a and receive connecting bumps described below.

A plurality of solder bumps 36, each bump 36 is formed on a respective one of the contact pads 22 of the chip 12. The chip 12 is placed over the solder mask 30 on the substrate 14 using conventional automated pick-and place equipment such that the solder bumps 36 contact their corresponding conductive patterns 24 on the substrate 14 through the openings 34, the remainder 36a of the solder bumps 34 are completely received in the openings 34 after a soldering process, and the outer surface 32 of the solder mask 30 is tightly attached by the active side 18 of the chip 12.

As shown in FIG.3, there depicts, in cross section, an IC chip package 40 according to a second embodiment of the present invention. In this embodiment, the package 40 has a molding material 42 around the perimeter of the chip 12. The molding material 42 exposes a region of the inactive side 20 of the chip 12 to allow a thermally and electrically conductive layer 44, for e.g., a copper paste, filled thereon.

As described above, according to the IC chip package of the present invention, since the active side of the chip is tightly attached to the smoothly formed outer surface of the solder mask, in other words, since being no gap formed therebetween, the prior art underfilling process is eliminated. Thus, the producing cost of the IC chip package will substantially be reduced and a thinnest IC chip package will be got.

Further, since the remainder of the solder bumps 36 after a soldering process can be totally received in the openings 34, the tendency to fail of the solder joints between the IC chip and the substrate because of the coefficient of thermal expansion mismatch will be reduced. Thus, the reliability of the IC package according to the present invention will be enhanced. Moreover, for having the thermally and electrical conductive layer 44 on the inactive (upper) side 20 of the IC chip 12, the package will render more efficient heat dissipation and better electrical performance.

## Claims

1. An improved flip chip package, comprising:
a substrate member having top and bottom surfaces, a conductive pattern at least on one of the surfaces;
the substrate made of a material including a first resin;
a solder mask made of a material including a second resin having a thermal expansion coefficient substantially identical to that of the first resin of the substrate;
the solder mask disposed on the top surface of the substrate such that a smooth outer surface is formed, the outer surface having a plurality of opening, each opening exposing a respective area of the conductive pattern of the substrate;
an IC chip having an active side, an inactive side and a plurality of electrical contact pads on the active side;
a plurality of solder bumps, each bump formed on a respective one of the plurality of contact pads on the IC chip;
the active side of the IC chip directly attached to the outer surface of the solder mask such that after a soldering process each said bump has a remainder completely received in a respective one of the opening of the solder mask and connected to the conductive patterns therein; and
a molding material encapsulating the chip and the top surface of the substrate.

2. The flip chip package of claim 1, wherein the molding material has an exposing region on the inactive side of the IC chip and a thermally and electrically conductive layer filled therein.

3. The flip chip package of claim 2, wherein the thermally and electrically conductive layer is a copper paste.

4. The flip chip package of claim 1, wherein the thickness of the solder mask is between 5 µm ∼30 µm.

5. The flip chip package of claim 1, wherein the first resin of the substrate and the second resin of the solder mask are an epoxy resin.

6. The flip chip package of claim 5, wherein the conductive vias are filled by the epoxy resin.

7. The flip chip package of claim 1, wherein the solder mask is disposed on the top surface of the substrate by a method comprising the following steps:
applying to the top surface a metal foil having a partially cured (B-staged) epoxy resin layer on one side of the foil such that the epoxy resin layer is sandwiched between the substrate and the metal foil;
laminating the metal foil and the substrate with a predetermined pressure and temperature for a period of time such that the epoxy resin layer is cured and tightly covers the substrate;
covering a photo-resist layer over the other side of the metal foil;
photocuring positions of the photo-resist layer and removing uncured areas of the photo-resist and the metal foil thereunder to expose the underlying epoxy resin layer;
removing the residual (cured) portion of the photo-resist;
etching away the exposed epoxy resin layer to expose conductive patterns to be soldered;
removing the residual metal foil, and leaving the cured epoxy resin layer as a solder mask.

8. The flip chip package of claim 7, wherein the metal foil is a copper foil.

9. The flip chip package of claim 7, wherein the metal foil is an aluminum foil.

10. The flip chip package of claim 7, wherein the thickness of the solder mask is between 5 µm ∼30 µm.
